# EUROPÄISCHE PATENTANMELDUNG

(11) **EP 1 418 634 A1**
(43) Veröffentlichungstag der Anmeldung: **12.05.2004**
(21) Anmeldenummer: 02090368.8
(22) Anmeldetag: 06.11.2002
(51) Int. Cl.: H01L 51/20

(54) **Display auf Basis organischer, lichtemittierender Bauelemente (OLED) mit niederohmigem Kathodenkontakt**

(71) Anmelder: Samsung SDI Co. Ltd., Suwon-city, Kyungki-do (KR)
(72) Erfinder: Uhlig, Albrecht, Dr., 12524 Berlin (DE); Fischer, Jörg, 13053 Berlin (DE); Zabel, Andreas, 10243 Berlin (DE)
(74) Vertreter: Hengelhaupt, Jürgen D., Dipl.-Ing.

(57) **Zusammenfassung**

Es ist Aufgabe der vorliegenden Erfindung, in einem Display auf Basis von OLED-Bauelementen den ohmschen Kontaktwiderstand zwischen Kathodenschicht und Kathodenkontaktschicht und damit die Leistungsaufnahme des Displays bei gleichbleibender Leistung zu verringern. Darüber hinaus soll ein Verfahren zur Herstellung eines erfindungsgemäßen Displays auf Basis von Bauelementen angegeben werden.

Dadurch, dass die elektrisch leitende Schicht (5) der Kathode zumindest teilweise die Kathodenkontaktschicht (7) direkt kontaktiert oder dass das OLED- Bauelement eine zusätzliche Verbindungsschicht (8) aus elektrisch leitfähigem Material aufweist, welche sowohl die elektrisch leitende Schicht (5) der Kathode als auch die Kathodenkontaktschicht (7) direkt kontaktiert, wird der ohmsche Kontaktwiderstand zwischen den Kathodenschichten (4, 5) und der Kathodenkontaktschicht (7) und damit die Leistungsaufnahme in dem Display auf Basis von OLED Bauelementen verringert.

## Beschreibung

Die Erfindung betrifft ein Display auf Basis organischer, lichtemittierender Bauelemente (OLED) mit niederohmigem Kathodenkontakt und ein Verfahren zu dessen Herstellung.

Displays auf der Basis organischer lichtemittierender Elemente (OLED) zeichnen sich durch hohe Brillianz und einen weiten Betrachtungswinkel aus. Als selbstemissive Technologie benötigen OLED-Displays keine Hintergrundbeleuchtung und können damit unter Bedingungen mit niedrigem bis mittlerem Umgebungslichtanteil energetisch vorteilhaft eingesetzt werden.

Bei OLED ist eine organische Halbleiterschicht (d.h. ein elektrolumineszierendes Material) zwischen zwei Elektroden angeordnet, wobei mindestens eine Elektrode für das emittierte Licht durchlässig sein soll.
Als Anode wird häufig Indium-Zinnoxid verwendet, welches auf ein Glassubstrat durch Beschichtung aufgebracht wird und im sichtbaren Spektralbereich transparent ist. Als Kathode wird üblicherweise ein Metall, z.B. Aluminium oder Silber, aufgedampft. Beim Anlegen einer Spannung kommt es zur Emission von Licht, dessen Farbe von der organischen Schicht abhängt. Um eine Lichtemission zu erreichen, müssen positive Ladungsträger (Defektelektronen oder "Löcher") aus der Anode sowie Elektronen aus der Kathode in das organische Material injiziert werden. Diese Ladungsträger wandern, beeinflußt durch das angelegte elektrische Feld, zum jeweiligen Gegenkontakt. Treffen dabei ein Elektron und ein "Loch" aufeinander, entsteht ein elektrisch neutrales, jedoch angeregtes Molekül. Dieses kehrt unter Aussendung von Licht in seinen Grundzustand zurück.

Für OLED sind Kathodenschichten mit einer Mehrlagenstruktur wie Lithiumfluorid/Kalzium/Aluminium oder Barium/Silber aus EP 1083612 A2 bekannt. Die Funktion des Lithiumfluorids bzw. des Kalziums bzw. des Bariums besteht darin, Elektronen in die lichtemittierende Schicht zu injizieren. Die Dicke der Lithiumfluoridschicht beträgt wenige Nanometer; die Dicke der Barium- bzw. der Kalziumschicht kann bis zu 100 nm betragen.
Die Funktion der Aluminium- oder Silberschicht besteht darin, den Hauptteil der Ladungen vom Kathodenanschluß zum lichtemittierenden Element, d.h. zur lichtemittierenden Schicht zu transportieren. Die Dicke dieser Schicht liegt im Bereich von 0,2 bis 2 µm. Dabei bildet die Schicht aus Lithiumfluorid, Kalzium oder Barium die sog. Elektroneninjektionsschicht, die Aluminium-/Silberschicht die elektrisch leitende Schicht der Kathode aus.

Zum elektrischen Kontaktieren der Kathode bzw. der Anode des Displaysubstrates bzw. des OLED mit einer externen Displaytreiberelektronik ist es bekannt, sog. flexible printed circuits (FPC) zu verwenden. Die FPC sind flexible Leiterplatten und bilden den Stand der Technik sowohl für die Herstellung für LCD-Displays als auch für OLED-Displays. Die Verbindung des FPC zum Displaysubstrat erfolgt mit Hilfe des Heißsiegelverfahrens mit einem anisotropen Klebefilm unter Druck- und Temperaturanwendung. Im Fall einer direkten Kontaktierung des FPC mit der Kathodenschicht würde diese Kathodenschicht durch die Druck- und Temperaturanwendung des Heißsiegelverfahrens zerstört werden. Um dies zu verhindern, wird der direkte Kontakt zwischen FPC und Kathodenschicht (Elektroneninjektionsschicht und elektrisch leitende Schicht) durch die Einführung einer Kathodenkontaktschicht vermieden. Eine solche Kathodenkontaktschicht kann z.B. aus Indium-Zinnoxid (ITO) bestehen. Der elektrische Kontakt zwischen dieser Kathodenkontaktschicht und der Kathode wird zum z.B. durch thermisches Verdampfen der Kathode auf einen Teil der Kathodenkontaktschicht z.B. unter Verwendung einer Schattenmaske hergestellt. Der freibleibende Teil der Kathodenkontaktschicht wird als Display- bzw. Bauelementeanschluss verwendet. Er kann somit als Verbindungsstelle zum FPC genutzt werden. Auf diese Weise wird ein elektrischer Kontakt zwischen Kathode und FPC realisiert, ohne dass die beiden Teile in direktem Kontakt miteinander stehen müssen. Die zwischen Kathode und FPC fließenden Ladungen werden über die Kathodenkontaktschicht transportiert. Die Kathode und die Kathodenkontaktfläche können je nach Displaytyp unterschiedliche Strukturen aufweisen.
Bei Displays mit matrixförmig angeordneten Pixeln ist es bekannt, die Kathode des Displays in Form von Kathodenlinien auszubilden, wobei eine Kathodenlinie mehrere Einzelpixel versorgt.
Nachteil einer solchen Struktur ist ein erhöhter elektrischer Widerstand entlang der Kathodenlinien. Um den ohmschen Abfall entlang einer Kathodenlinie zu verringern, ist es aus JP 10294183 bekannt, eine Hilfskathode, bestehend aus einem hochstromleitfähigen Material zu nutzen. Derselbe Ansatz ist aus JP 2001015268 für eine Anode bekannt. Weiterhin ist es aus JP 2001282136 bekannt, Aluminium als Hilfsschicht unter einer aus ITO bestehenden Kathodenkontaktschicht zu verwenden, um den ohmschen Verlust entlang der Kathodenkontaktschichten und -linien zu vermeiden. Nachteilig hieran ist, dass nach wie vor ein erhöhter elektrischer Kontaktwiderstand zwischen der Kathode und der Kathodenkontaktschicht besteht. Bei einer Mehrlagenkathode bestehend aus einer Elektroneninjektionsschicht und einer elektrisch leitenden Schicht weisen Kalzium, Barium und Lithiumfluorid einen relativ hohen ohmschen Widerstand auf. Die dünnen Kalziumoder Bariumschichten werden zumindest teilweise durch Restsauerstoff auf dem Substrat oder in der Verdampferanlage zu Kalziumoxid oder Bariumoxid oxidiert, welche ebenfalls elektrische Isolatoren sind. Dadurch erhöht sich der elektrische Widerstand des Kontakts zwischen der Kathode und der Kathodenkontaktschicht. Dieser erhöhte elektrische Kontaktwiderstand führt durch ohmschen Verlust an dieser Stelle zu einer unerwünschten erhöhten Leistungsaufnahme des OLED bzw. des Displays. Dies kann weiterhin zu einer unerwünschten Wärmeentwicklung führen.

Es ist daher Aufgabe der vorliegenden Erfindung, in einen Display auf Basis von OLED-Bauelementen den ohmschen Kontaktwiderstand zwischen Kathodenschicht und Kathodenkontaktschicht und damit die Leistungsaufnahme der OLED-Bauelemente bei gleichbleibender Leistung zu verringern. Darüber hinaus soll ein Verfahren zur Herstellung eines erfindungsgemäßen OLED-Bauelements angegeben werden.

Diese Aufgabe wird erfindungsgemäß gelöst durch die Merkmale im kennzeichnenden Teil des Anspruchs 1 (Sachanspruch) und die Merkmale im kennzeichnenden Teil des Anspruchs 9 (Verfahrensanspruch) im Zusammenwirken mit den Merkmalen im Oberbegriff. Zweckmäßige Ausgestaltungen der Erfindung sind in den Unteransprüchen enthalten.

Dadurch, dass die elektrisch leitende Schicht der Kathode zumindest teilweise die Kathodenkontaktschicht direkt kontaktiert oder dass das organische lichtemittierende Element eine zusätzliche Verbindungsschicht aus elektrisch leitfähigem Material aufweist, welche sowohl die elektrisch leitende Schicht der Kathode als auch die Kathodenkontaktschicht kontaktiert, wird der ohmsche Kontaktwiderstand zwischen der Kathode und der Kathodenkontaktschicht und damit die Leistungsaufnahme eines OLED-Bauelements in einem Display verringert. Die elektrisch leitende Schicht der Kathode kann aus Aluminium oder Silber bestehen. Die Elektroneninjektionsschicht der Kathode kann aus Kalzium und/oder Barium und/oder Lithiumfluorid und/oder Kalziumoxid und/oder Bariumoxid bestehen.
Die Verbindungsschicht, welche sowohl die elektrisch leitende Schicht der Kathode als auch die Kathodenkontaktschicht kontaktiert, kann aus Gold oder Kupfer bestehen. Die lichtemittierende Schicht kann aus lichtemittierenden Polymeren, z.B. aus der Familie der Polyphenylenvinylene (PPVs) oder der Polyfluorene(PFOs) bestehen.
Die lichtemittierende Schicht kann alternativ aus Polyethylene-dioxythiophene und einem lichtemittierenden Polymer, z.B. Paraphenylene vinylene oder aus einer Lochinjektionsschicht, wie z.B. N,N'-Di(naphthalen-1-yl)-N,N'-diphenyl-benzidine und einer lichtemittierenden, elektronenleitenden Schicht, z.B. 8-hydroxyquionoline aluminum bestehen. Die Anodenschicht und die Kathodenkontaktschicht können aus Indium-Zinnoxid bestehen.

Erfindungsgemäß wird zur Herstellung eines OLED-Displays die Elektroneninjektionsschicht lediglich im Bereich der lichtemittierenden Schicht aufgebracht, wobei die elektrisch leitende Schicht der Kathode sowohl im Bereich der lichtemittierenden Schicht als auch zumindest teilweise im Bereich der Kathodenkontaktschicht aufgebracht wird oder es wird sowohl die Elektroneninjektionsschicht als auch die elektrisch leitende Schicht lediglich im Bereich der lichtemittierenden Schicht aufgebracht, wobei zusätzlich eine Verbindungsschicht aufgebracht wird, welche sowohl die elektrisch leitende Schicht der Kathode als auch die Kathodenkontaktschicht direkt kontaktiert
Die Abscheidung der Elektroneninjektionsschicht bzw. der elektrisch leitenden Schicht auf der Kathodenkontaktschicht wird durch Abdeckung mittels einer Schattenmaske verhindert. Die zusätzliche Verbindungsschicht kann ebenfalls durch eine Schattenmaske aufbracht werden.

Die Erfindung wird nachstehend anhand eines Ausführungsbeispiels näher erläutert.
Es zeigen:
- Fig. 1:: einen schematischen Querschnitt eines OLED-Bauelementes im OLED-Display nach dem Stand der Technik,
- Fig. 2:: einen schematischen Querschnitt eines erfindungsgemäßen OLED-Bauelementes in einem OLED-Display, wobei die elektrisch leitende Schicht der Kathode die Kathodenkontaktschicht direkt kontaktiert,
- Fig. 3:: einen schematischen Querschnitt eines erfindungsgemäßen OLED-Bauelementes in einem OLED-Display mit einer zusätzlichen Verbindungsschicht aus elektrisch leitfähigem Material, welche sowohl die elektrisch leitende Schicht der Kathode als auch die Kathodenkontaktschicht direkt kontaktiert.

Mehrlagenkathoden weisen einen erhöhten Kontaktwiderstand zur Kathodenkontaktschicht (ITO) im Vergleich zu einer Einlagenkathode aus Aluminium auf. Wird der relative Kontaktwiderstand der Einlagenkathode aus Aluminium (500 nm) zur Kathodenkontaktschicht (ITO) auf 100% gesetzt, beträgt der relative Kontaktwiderstand einer Lithiumfluorid/Kalzium/Aluminium - Kathode (1nm/10nm/500nm) 111%, der relative Kontaktwiderstand einer Lithiumfluorid/Aluminium - Kathode (1nm/500nm) 695% und der relative Kontaktwiderstand einer Kalzium/Aluminium - Kathode (10nm/500nm) 157 %. Der höhere relative Kontaktwiderstand der Mehrlagenkathoden (mit einer Elektroneninjektionsschicht) ist darauf zurückzuführen, dass Kalzium oder Barium durch Restsauerstoff auf dem Substrat oder in einer Verdampferanlage zumindest teilweise oxidieren und somit elektrische Isolatoren darstellen. Lithiumfluorid stellt ohnehin eine elektrischen Isolator dar. Auf diese Schichten kann jedoch in vielen Fällen nicht verzichtet werden, da die Funktion des Lithiumfluorids bzw. der Kalziums bzw. des Bariums darin besteht, Elektronen in die lichtemittierende Schicht zu injizieren.
Es ist daher einerseits wünschenswert, Elektroneninjektionsschichten verwenden zu können; andererseits soll der relative Kontaktwiderstand zwischen Kathode und Kathodenkontaktschicht möglichst gering sein. Um dieses Ziel zu erreichen, muss die Bedeckung der Kathodenkontaktschicht mit einem elektrischen Isolator wie Lithiumfluorid, Bariumoxid oder Kalziumoxid verhindert werden.

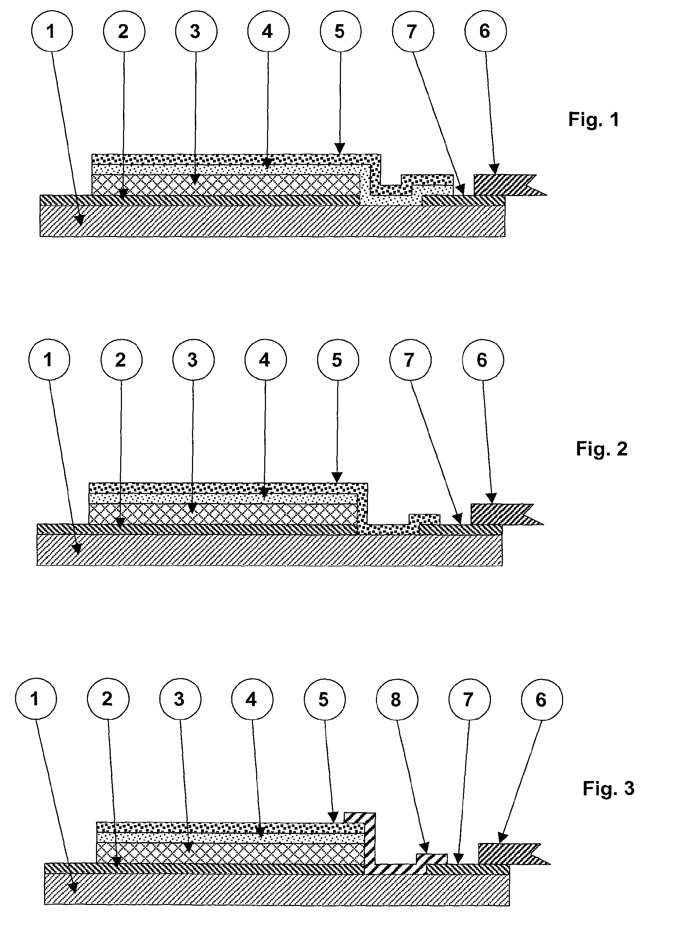

In Fig. 1 ist der schematische Querschnitt eines OLED-Bauelements in einem OLED-Display nach dem Stand der Technik dargestellt. Auf einem Substrat 1 ist eine Anodenschicht 2 angeordnet. Auf dieser Anodenschicht 2 ist eine lichtemittierende Schicht 3 angeordnet, welche die Pixelfläche darstellt. Weiterhin ist eine Kathodenkontaktschicht 7 auf dem Substrat 1 angeordnet, welche die Anodenschicht 2 nicht kontaktiert. Über der lichtemittierenden Schicht 3 und einem Teil der Kathodenkontaktschicht 7 ist eine Elektroneninjektionsschicht 4, z.B. aus Lithiumfluorid angeordnet. Darüber ist die elektrisch leitende Schicht 5 der Kathode angeordnet, welche z.B. aus Aluminium besteht. Auf dem nicht durch die Kathodenschichten 4,5 überdeckten Teil der Kathodenkontaktschicht 7 ist das FPC 6 (flexibel printed circuits) angeordnet. Auf diese Weise wird ein elektrischer Kontakt zwischen der Kathode, die aus der Elektroneninjektionsschicht 4 und der elektrisch leitenden Schicht 5 besteht, und dem FPC 6 realisiert, ohne dass die beiden Schichten 5, 6 direkt in Kontakt treten müssen. Ein solcher direkter Kontakt ist wegen einer möglichen Beschädigung der Kathode (elektrisch leitende Schicht) durch das Heißsiegelverfahren nicht möglich, mit welchem das FPC 6 aufgebracht wird.
Um den relativ hohen Kontaktwiderstand zwischen Kathodenkontaktschicht 7 und Kathode zu verringern, wird erfindungsgemäß die Bedeckung der Kathodenkontaktschicht 7 mit einer elektrisch isolierenden Schicht (Elektroneninjektionsschicht), wie Lithiumfluorid oder Kalziumoxid oder Bariumoxid verhindert. Das bedeutet, dass ein direkter Kontakt zwischen der elektrisch leitenden Schicht 5 und der Kathodenkontaktschicht 7 realisiert wird. Ein organisches lichtemittierendes Element in einem erfindungsgemäßen OLED-Display ist in Fig. 2 schematisch dargestellt. Eine Anodenschicht 2 ist auf einem Substrat 1 angeordnet. Über der Anodenschicht 2 ist eine lichtemittierende Schicht 3 angeordnet, welche die spätere Pixelfläche ausbildet. Eine Kathodenkontaktschicht 7 ist außerhalb der Pixelfläche auf dem Substrat 1 angeordnet. Die Elektroneninjektionsschicht 4, welche aus einer isolierenden Schicht wie Lithiumfluorid, Kalziumoxid oder Bariumoxid besteht, wird lediglich im Bereich der lichtemittierenden Schicht 3 aufgebracht. Dies kann z.B. durch Verwendung verschiedener Schattenmasken bei der thermischen Verdampfung der einzelnen Kathodenschichten, z.B. einer Maske für die Elektroneninjektionsschicht 4, wie LiF oder Kalzium, und einer zweiten Maske für die elektrisch leitende Schicht 5, wie Aluminium oder Silber, realisiert werden.
In einem ersten Verdampfungsschritt wird LiF und Kalzium nur auf die lichtemittierende Schicht 3 des OLED-Bauelements verdampft. Die Abscheidung von LiF oder Kalzium auf die Kathodenkontaktfläche 7 wird durch Abdecken dieser durch eine Schattenmaske verhindert. In einem weiteren Schritt wird Aluminium oder Silber durch eine weitere Schattenmaske sowohl auf die LiF-/Ca-Schicht im Bereich der lichtemittierenden Schicht 3 als auch auf einen Teil der Kathodenkontaktschicht 7 abgeschieden, wie in Fig. 2 dargestellt ist. Hierdurch entsteht ein direkter elektrischer Kontakt zwischen Kathodenkontaktschicht 7 und elektrisch leitender Schicht 5, was zu einem verringerten relativen Kontaktwiderstand führt.

Ein weiteres organisches lichtemittierendes Baulelement in einem erfindungsgemäßen OLED-Display ist in Fig. 3 schematisch dargestellt. Wiederum besteht das OLED aus einem Substrat 1 angeordneten Anodenschicht 2, und einer davon räumlich abgetrennten Kathodenkontaktschicht 7. Über der Anodenschicht 2 ist eine lichtemittierende Schicht 3 angeordnet. Auf der lichtemittierenden Schicht 3 ist eine Elektroneninjektionsschicht 4 und eine elektrisch leitende Schicht 5 angeordnet. In diesem Beispiel wurde die Schattenmaske für das Verdampfen der Elektroneninjektionsschicht 4 und der elektrisch leitenden Schicht 5 so gewählt, dass diese Schichten nicht die Kathodenkontaktschicht 7 kontaktieren. Erfindungsgemäß ist eine Verbindungsschicht 8 aus leitfähigem Material sowohl über der elektrisch leitenden Schicht 5 der Kathode als auch über der Kathodenkontaktschicht 7 aufgebracht, welche den elektrischen Kontakt zwischen diesen beiden Schichten 5, 7 herstellt. Diese Verbindungsschicht 8, welche die elektrisch leitende Schicht 5 und die Kathodenkontaktschicht 7 verbindet, besteht aus einem elektrisch hoch leitfähigen Material, welches auf einem besonders niedrigen elektrischen Kontaktwiderstand sowohl zur elektrisch leitenden Schicht 5 der Kathode als auch zur Kathodenkontaktschicht 7 hin optimiert ist. Diese Schicht kann z. B. aus Kupfer oder Gold bestehen. Hierdurch wird ein verringerter relativer Kontaktwiderstand zwischen Kathodenkontaktschicht 7 und Kathode (bestehend aus Elektroneninjektionsschicht 4 und elektrisch leitender Schicht 5) realisiert.

Die Erfindung ist nicht beschränkt auf die hier dargestellten Ausführungsbeispiele, vielmehr ist es möglich, durch Kombination und Modifikation der genannten Mittel und Merkmale weitere Ausführungsvarianten zu realisieren, ohne den Rahmen der Erfindung zu verlassen.

### Bezugszeichenliste

- 1: Substrat
- 2: Anodenschicht
- 3: lichtemittierende Schicht
- 4: Elektroneninjektionsschicht
- 5: elektrisch leitende Schicht
- 6: FPC (flexible printed circuits)
- 7: Kathodenkontaktschicht
- 8: Verbindungsschicht

## Patentansprüche

1. Display auf Basis organischer, lichtemittierender Bauelemente (OLED) mit einer Anodenschicht, einer lichtemittierenden Schicht, einer Kathodenschicht, welche eine Elektroneninjektionsschicht und eine elektrisch leitende Schicht umfaßt, und einer Kathodenkontaktschicht zur elektrischen Verbindung der Kathodenschicht mit einer Bildschirmtreiberelektronik, **dadurch gekennzeichnet, dass** die elektrisch leitende Schicht (5) der Kathode zumindest teilweise die Kathodenkontaktschicht (7) direkt kontaktiert oder dass das OLED eine zusätzliche Verbindungsschicht (8) aus elektrisch leitfähigem Material aufweist, welche sowohl die elektrisch leitende Schicht (5) der Kathode als auch die Kathodenkontaktschicht (7) direkt kontaktiert.

2. DISPLAY nach Anspruch 1, **dadurch gekennzeichnet, dass** die Elektroneninjektionsschicht (4) aus Lithiumfluorid Barium und/oder Kalzium und/oder Bariumoxid und/oder Kalziumoxid besteht.

3. DISPLAY nach Anspruch 1 oder 2, **dadurch gekennzeichnet, dass** die Verbindungsschicht (8) aus Kupfer oder Gold besteht.

4. DISPLAY nach Anspruch 1 bis 3, **dadurch gekennzeichnet, dass** die lichtemittierende Schicht (3) aus lichtemittierenden Polymeren, z.B. aus der Familie der Polyphenylenvinylene (PPVs) oder der Polyfluorene(PFOs) besteht.

5. DISPLAY nach Anspruch 1 bis 3, **dadurch gekennzeichnet, dass** die lichtemittierende Schicht (3) aus Polyethylene-dioxythiophene und einem lichtemittierenden Polymer, z.B. Paraphenylene vinylene besteht.

6. DISPLAY nach Anspruch 1 bis 3, **dadurch gekennzeichnet, dass** die lichtemittierende Schicht (3) aus einer Lochinjektionsschicht, wie z.B. N,N'-Di(naphthalen-1-yl)-N,N'-diphenyl-benzidine, und einer lichtemittierenden, elektronenleitenden Schicht, z.B. 8-hydroxyquionoline aluminum besteht.

7. DISPLAY nach Anspruch 1 bis 6, **dadurch gekennzeichnet, dass** die elektrisch leitende Schicht (5) aus Aluminium oder Silber besteht.

8. DISPLAY nach Anspruch 1 bis 7, **dadurch gekennzeichnet, dass** die Anodenschicht (2) oder die Kathodenkontaktschicht (7) aus Indium-Zinnoxid (ITO) besteht.

9. Verfahren zur Herstellung eines OLED-Displays durch Aufbringen einer Anodenschicht auf ein Substrat, Aufbringen einer Kathodenkontaktschicht, Aufbringen einer lichtemittierenden Schicht, Aufbringen einer Elektroneninjektionsschicht und Aufbringen einer elektrisch leitenden Schicht, **dadurch gekennzeichnet, dass** die Elektroneninjektionsschicht (4) lediglich im Bereich der lichtemittierenden Schicht (3) aufgebracht wird, wobei die elektrisch leitende Schicht (5) sowohl im Bereich der lichtemittierenden Schicht (3) als auch zumindest teilweise im Bereich der Kathodenkontaktschicht (7) aufgebracht wird, oder
dass sowohl die Elektroneninjektionsschicht (4) als auch die elektrisch leitende Schicht (5) lediglich im Bereich der lichtemittierenden Schicht (3) aufgebracht werden und weiterhin eine zusätzliche Verbindungsschicht (8) aufgebracht wird, welche sowohl die elektrisch leitende Schicht (5) der Kathode als auch die Kathodenkontaktschicht (7) direkt kontaktiert.

10. Verfahren nach Anspruch 9, **dadurch gekennzeichnet, dass** die Abscheidung der Elektroneninjektionsschicht (4) und/oder der elektrisch leitenden Schicht (5) auf der Kathodenkontaktschicht (7) durch Abdeckung mittels einer Schattenmaske verhindert wird.

11. Verfahren nach Anspruch 9 oder 10, **dadurch gekennzeichnet, dass** die Verbindungsschicht (8) mittels einer Schattenmaske aufgebracht wird.
